# FASCICULE DE BREVET EUROPEEN

(11) **EP 4 034 692 B1**
(45) Date de publication et mention de la délivrance du brevet: **19.11.2025**
(21) Numéro de dépôt: 20796864.5
(22) Date de dépôt: 28.09.2020
(51) Int. Cl.: C23F 1/28, H10D 30/01, H10D 30/60, H01L 21/28, H01L 21/285, H01L 21/3213

(54) **COMPOSITION CHIMIQUE POUR RETIRER DES RESIDUS EN ALLIAGE NICKEL-PLATINE D'UN SUBSTRAT, ET PROCEDE DE RETRAIT DE TELS RESIDUS**
CHEMISCHE ZUSAMMENSETZUNG ZUM ENTFERNEN VON NICKELPLATIN-LEGIERUNGSRESTEN VON EINEM SUBSTRAT UND VERFAHREN ZUM ENTFERNEN SOLCHER RESTE
CHEMICAL COMPOSITION FOR REMOVING NICKEL-PLATINUM ALLOY RESIDUES FROM A SUBSTRATE, AND METHOD FOR REMOVING SUCH RESIDUES

(30) Priorité: 27.09.2019 FR 1910737
(43) Date de publication de la demande: 03.08.2022
(73) Titulaire: Technic France, 93200 Saint Denis (FR)
(72) Inventeur: PIZZETTI, Christian, 38490 La Batie Divisin (FR); AUDOUIN, Marine, 38000 Grenoble (FR)
(74) Mandataire: Regimbeau
(86) Numéro de dépôt international: PCT/FR2020/051693
(87) Numéro de publication internationale: WO 2021/058927

(56) Documents cités:
- WO-A1-2013/170130
- WO-A1-2014/178326
- US-A1- 2008 315 322

## Description

### DOMAINE TECHNIQUE DE L'INVENTION

La présente invention concerne une composition chimique pour retirer des résidus en alliage nickel-platine d'un substrat, et un procédé de retrait de tels résidus.

### ETAT DE LA TECHNIQUE

Lors de la fabrication de transistors MOS (métal-oxyde-semi-conducteur), les connexions métalliques sont reliées au substrat par l'intermédiaire de siliciures (MxSiy) qui sont formés lors d'un ou plusieurs recuits en température, après avoir déposé une fine couche de métal ou d'un alliage surmontée d'une fine couche de nitrure de titane permettant de protéger la couche de métal de l'oxydation.

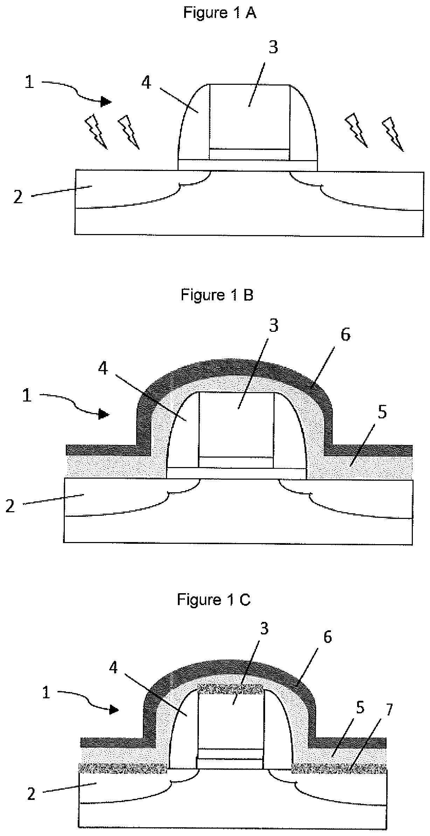

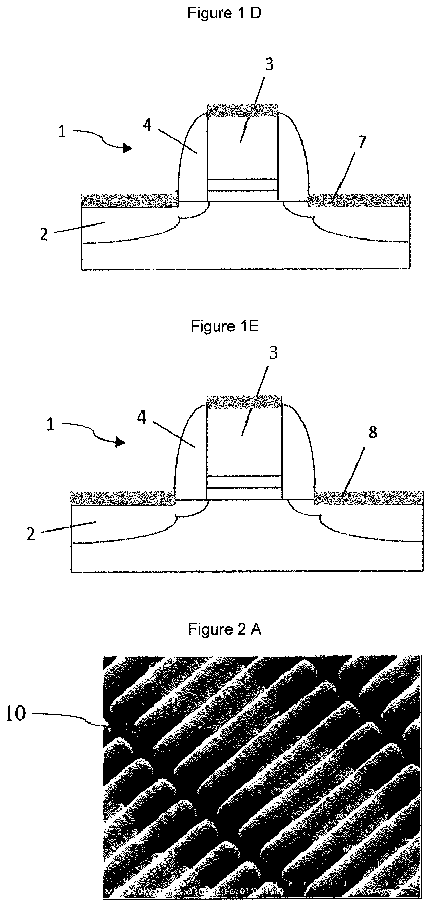

Les figures 1A, 1B, 1C, 1D, et 1E illustrent différents états de la structure 1 destinée à former le transistor MOS, lors des étapes de fabrication de ce dernier.

Sur la figure 1A, la structure 1 comprend une zone implantée 2 de type N ou P, une grille 3 composée de polysilicium et de nitrure de titane, déposée sur une couche d'un matériau isolant à haute constante diélectrique, et un espaceur 4 en un matériau diélectrique, tel que du nitrure de silicium SiN. En référence à la figure 1B, on dépose la couche métallique 5 et la couche 6 de nitrure de titane TiN. La couche métallique comprend généralement une couche en alliage de nickel-platine (contenant 8 à 15% massique de platine) pour des raisons de stabilité thermique.

On effectue un premier recuit de siliciuration, à basse température, pour former une première phase riche en métal, comprenant une couche 7 de siliciure de nickel Ni₂Si illustrée sur la figure 1C. Un deuxième recuit permet de transformer la couche 7 de Ni₂Si en une couche 8 de NiSi comme illustré sur la figure 1E.

Cependant, le premier recuit de siliciuration conduit à la formation de résidus de la couche en alliage de nickel-platine qui n'ont pas été transformés, comme le montre la figure 1D. Ces résidus doivent être retirés de manière sélective par rapport à la couche de diélectrique située sous la grille et par rapport au siliciure de nickel Ni₂Si formé, ces derniers étant alors exposés. La présence de platine dans l'alliage constitutif de ces résidus rend leur dissolution d'autant plus difficile que leur concentration en platine est élevée.

Lorsque le platine est présent dans l'alliage de Nickel-Platine à une concentration inférieure 8% massique, alors des solutions habituellement utilisées pour le retrait de nickel pur ou de cobalt sont efficaces. Parmi ces solutions, le plus couramment rencontré est le mélange HCl (37% massique) et eau oxygénée (30% massique) appelé SC2 dans des proportions en HCl :H₂O₂ :H₂O allant de 1 :1 :50 à 1 :1 :10 en ratio volumique et à des températures comprises entre 50 et 70°C.

Deux compositions ont été mises au point par des industriels pour retirer une couche d'alliage nickel-platine Ni-Pt contenant au moins 8% massique de Platine.

La première composition est un mélange d'acide chlorhydrique concentré et d'acide nitrique concentré, dont le nom d'usage est Aqua Regia. Ce mélange est en général efficace pour dissoudre les résidus, mais présente en revanche une agressivité trop importante vis-à-vis du siliciure formé. De plus, cette composition n'est utilisable qu'après un certain délai suivant le mélange, et pour une durée relativement courte, comprise généralement entre une et trois heures. Enfin, l'utilisation de cette composition nécessite une étape préliminaire de retrait de la couche de nitrure de titane.

La deuxième composition est un mélange au point d'utilisation d'acide sulfurique concentré chauffé à 60-80°C et de peroxyde d'hydrogène à 30% massique, dont le nom d'usage est S.P.M. Le mélange ainsi réalisé permet d'atteindre une température de procédé comprise entre 180°C et 200°C, ce qui permet un retrait relativement rapide des résidus. Ce mélange permet en outre de retirer la couche de nitrure de titane qui couvre la couche d'alliage nickel-platine Ni-Pt.

L'utilisation de cette composition S.P.M présente cependant plusieurs inconvénients. La température très élevée nécessaire au retrait du platine rend la solution agressive vis-à-vis des matériaux constitutifs des équipements de traitement mais aussi et surtout vis-à-vis des métaux présents dans la structure du transistor (notamment le métal de la grille) ce qui peut conduire à des pertes significatives de rendement fonctionnel du transistor.

Un procédé de retrait sélectif de résidus en alliage nickel-platine d'un substrat est décrite dans les documents WO 2014/178326 A1, US 2008/315322 A1 et WO 2013/170130 A1.

### BREVE DESCRIPTION DE L'INVENTION

Un but de l'invention est de surmonter les inconvénients détaillés précédemment.

Dans la présente invention, Ni désigne le nickel et Pt désigne le platine.

L'invention vise notamment à fournir une composition chimique aqueuse pour retirer des résidus d'un alliage nickel-platine d'un substrat, en particulier des résidus d'un alliage Ni-Pt contenant au moins 8% massique de Pt. La composition selon l'invention permet un retrait efficace desdits résidus tout en évitant de dégrader le substrat, et tout particulièrement le silicium et/ou le nitrure de titane constitutif du substrat.

L'invention a également pour but de fournir une telle composition chimique aqueuse permettant de retirer des résidus d'un alliage nickel-platine, contenant en particulier au moins 8% massique de Pt, formés par recuit d'une structure comprenant une couche en alliage de nickel-platine lors de la fabrication d'un transistor, de manière efficace et en évitant de dégrader la structure, en particulier la grille du transistor et/ou les couches constitutives du transistor.

La présente invention concerne une composition chimique aqueuse C pour retirer d'un substrat sélectivement à chaud des résidus d'un alliage nickel-platine contenant au moins 8% massique de Pt par rapport au poids total de l'alliage nickel-platine, caractérisée en ce qu'elle est préparée par mélange d'une composition B comprenant des ions bromure et d'une composition H comprenant du peroxyde d'hydrogène de sorte que dans la composition C, au moment du mélange, la concentration molaire en ions bromure est comprise entre 0,15 mol/L et 0,45 mol/L et le ratio molaire du peroxyde d'hydrogène par rapport aux ions bromures est compris entre 1,1 et 2.

La présente invention concerne également l'utilisation de la composition chimique aqueuse C selon l'invention pour retirer d'un substrat sélectivement à une température supérieure ou égale à 70°C, des résidus d'un alliage nickel-platine contenant au moins 8% massique de Pt par rapport au poids total de l'alliage nickel-platine. Le substrat est en particulier un transistor.

Enfin, la présente invention concerne un procédé de retrait sélectif de résidus en alliage nickel-platine contenant au moins 8% massique de Pt par rapport au poids total de l'alliage nickel-platine d'un substrat, en particulier d'un transistor, comprenant les étapes suivantes:
- préparer à chaud une composition chimique aqueuse C selon l'invention,
- mettre en contact la composition chimique chaude et le substrat pendant une durée suffisante pour retirer les résidus en alliage nickel-platine du substrat, caractérisé en ce que la composition chimique C est à une température supérieure ou égale à 70°C lors de sa mise en contact avec le substrat.

Selon un mode de réalisation, la composition chimique est constituée uniquement, ou essentiellement, d'une source d'ions bromure, de l'eau oxygénée, et de l'eau.

Selon d'autres aspects, la composition selon l'invention présente les différentes caractéristiques suivantes prises seules ou selon leurs combinaisons techniquement possibles :
- les ions bromure sont issus de l'acide bromhydrique, du bromure d'hydrogène ou d'un sel de bromure ;
- la composition B selon l'invention comprend en outre des ions chlorures à un ratio molaire par rapport aux ions bromures inférieur ou égal à 0,25;
- la concentration molaire en eau oxygénée est supérieure à la concentration molaire en ions bromure.

La demande décrit un procédé de retrait sélectif de résidus en alliage nickel-platine d'un substrat, comprenant les étapes suivantes :
- mélanger des ions bromure et de l'eau oxygénée dans de l'eau pour former une composition chimique C telle que décrite précédemment,
- mettre en contact la composition chimique et le substrat pendant une durée suffisante pour retirer les résidus en alliage nickel-platine du substrat.

Selon d'autres aspects, la demande décrit un procédé qui présente les différentes caractéristiques suivantes prises seules ou selon leurs combinaisons techniquement possibles:
- la composition chimique est préparée en mélangeant l'eau à une température supérieure à 75°C, avec les ions bromure et l'eau oxygénée ;
- la composition chimique est fabriquée en injectant au point d'utilisation, dans un flux d'eau chauffée à une température supérieure à 75°C, les ions bromure et l'eau oxygénée ;
- les ions bromure sont issus de l'acide bromhydrique présentant un titre massique de 48% et sont injectés dans le flux d'eau chauffée à un débit compris entre 2% et 5,5% du débit volumique d'eau, et l'eau oxygénée présente un titre massique de 30% et est injectée dans le flux d'eau chauffée à un débit compris entre 2 et 6 % du débit volumique d'eau ;
- la composition chimique est à une température supérieure ou égale à 70°C lors de sa mise en contact avec le substrat ;
- le substrat est une structure de transistor comprenant les résidus en alliage nickel-platine formés par recuit lors de la fabrication du transistor.

### DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
[Fig. 1A] est un schéma en coupe d'une structure destinée à former un transistor ;
[Fig. 1B] est un schéma en coupe de la structure de Fig. 1A après dépôt d'une couche métallique et d'une couche de nitrure de titane TiN ;
[Fig. 1C] est un schéma en coupe de la structure de Fig. 1B après la réalisation d'un premier recuit de siliciuration ;
[Fig. 1D] est un schéma en coupe de la structure de Fig. 1C après une tentative de retrait de résidus en alliage nickel-platine ;
[Fig. 1E] est un schéma en coupe de la structure de Fig. 1D après la réalisation d'un second recuit ;
[Fig. 2A] est une première vue au microscope électronique à balayage d'une structure d'un transistor après retrait de résidus, lesdits résidus ayant été totalement retirés ;
[Fig. 2B] est une deuxième vue au microscope électronique à balayage de la structure de Fig. 2A ;
[Fig. 3] est une vue au microscope électronique à balayage d'une structure d'un transistor après retrait de résidus, lesdits résidus n'ayant été que partiellement retirés.
[Fig. 4] est une vue au microscope électronique à balayage d'une structure d'un transistor après retrait de résidus après traitement SC2, lesdits résidus n'ayant été que partiellement retirés.
[Fig. 5] est un schéma d'un premier mode de réalisation de l'étape de préparation de la composition chimique aqueuse C selon l'invention.
[Fig. 6] est un schéma d'un second mode de réalisation de l'étape de préparation de la composition chimique aqueuse C selon l'invention.
[Fig. 7] est un schéma d'un troisième mode de réalisation de l'étape de préparation de la composition chimique aqueuse C selon l'invention.
[Fig. 8] est un schéma d'un quatrième mode de réalisation de l'étape de préparation de la composition chimique aqueuse C selon l'invention.

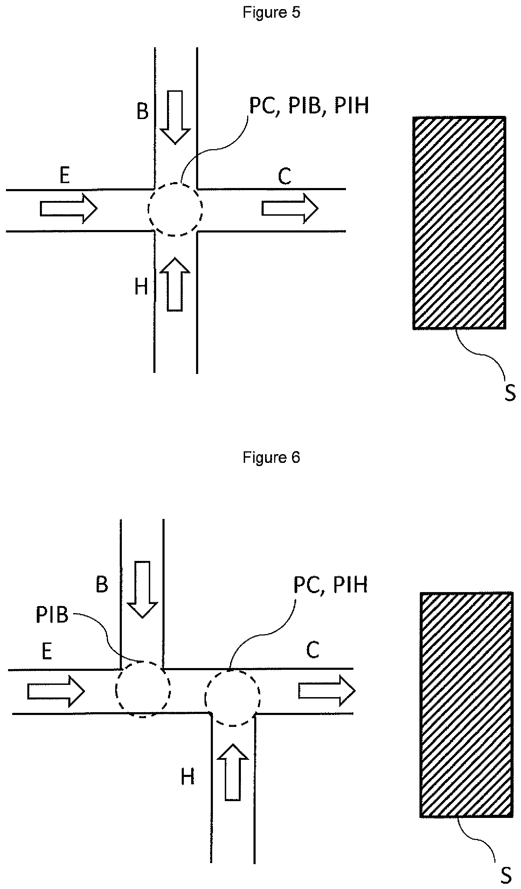

Dans les figures 5 à 8, « E » = eau, « B » = composition B, « H » = composition H, « C » = composition C, « S » = substrat, « PC » = point de contact, « PIB » = point d'injection de la composition B, « PIH » = point d'injection de la composition H, « R » = réservoir.

### DESCRIPTION DETAILLEE DE MODES DE REALISATION DE L'INVENTION

### Composition aqueuse C selon l'invention

La composition chimique selon l'invention est une composition chimique aqueuse C, adaptée pour retirer d'un substrat sélectivement à chaud des résidus d'un alliage nickel-platine contenant au moins 8% massique de Pt par rapport au poids total de l'alliage nickel-platine, caractérisée en ce qu'elle est préparée par mélange d'une composition B comprenant des ions bromure et d'une composition H comprenant du peroxyde d'hydrogène de sorte que dans la composition C, au moment du mélange , la concentration molaire en ions bromure est comprise entre 0,15 mol/L et 0,45 mol/L et le ratio molaire du peroxyde d'hydrogène par rapport aux ions bromures est compris entre 1,1 et 2.

Avantageusement, la composition C est préparée par le mélange exclusif de la composition B, de la composition H et optionnellement de l'eau. Ainsi, de préférence, la composition C ne comprend que les éléments introduits par les compositions B et H, les éléments résultant de la réaction des compositions B et H, le cas échéant l'eau supplémentaire éventuellement introduite, à l'exclusion de tout autre élément. En d'autres termes, de préférence, la composition C est constituée les éléments introduits par les compositions B et H, les éléments résultant de la réaction des compositions B et H, et le cas échéant l'eau supplémentaire éventuellement introduite.

Par « au moment du mélange », on entend notamment lors du mélange de la composition B et de la composition H, et optionnellement de l'eau supplémentaire.

Les résidus d'alliage nickel-platine résultent notamment de la mise en oeuvre d'une siliciuration d'un substrat lors de la fabrication d'un transistor, c'est-à-dire d'une étape consistant à former un siliciure (composé chimique comprenant du silicium et un métal) par recuit thermique. A l'issue de la siliciuration, le substrat comprend la structure destinée à former le transistor, laquelle est recouverte des résidus d'un alliage nickel-platine non transformés lors de la réaction. Cet alliage nickel-platine va comprendre au moins 8% en masse de platine, avantageusement de 8% à 15% en masse de platine, par rapport au poids total de l'alliage nickel-platine.

La composition selon l'invention permet avantageusement de retirer ces résidus efficacement et sélectivement vis-à-vis du siliciure formé et de la couche de diélectrique située sous la grille du transistor, en un temps suffisamment court pour être compatible avec les besoins industriels. Sans être lié par une théorie particulière, on peut penser que ces propriétés proviennent du mélange d'ions bromures avec du peroxyde d'hydrogène formant du dibrome Br₂, libérant des radicaux libres Br° et favorisant la décomposition radicalaire de l'eau oxygénée en HO° dans la composition, ces radicaux étant susceptibles de former relativement facilement des complexes avec le platine.

Le retrait sélectif a lieu à chaud, c'est-à-dire à une température supérieure ou égale à 70°C, en particulier supérieure ou égale à 75°C, plus particulièrement comprise entre 75°C et 95°C.

Les entités chimiques réagissant rapidement l'une sur l'autre, les teneurs en ions bromure et en peroxyde d'hydrogène données correspondent aux teneurs présentes lors du mélange, c'est-à-dire lors du mélange de la composition B avec la composition H, l'eau supplémentaire, lorsqu'elle est introduite étant présente au moment du mélange.

### - Composition B

La composition B comprend des ions bromure. Avantageusement, la composition B comprend une source d'ions bromures. Un ion bromure est un ion de formule Br-.

La source d'ions bromure peut être l'acide bromhydrique, un sel de bromure ou du bromure d'hydrogène (gaz). En particulier, la composition B comprend de l'acide bromhydrique, un sel de bromure ou du bromure d'hydrogène.

L'acide bromhydrique est une solution aqueuse de bromure d'hydrogène. Il est obtenu par dissolution du gaz HBr dans de l'eau. Il s'agit d'une solution aqueuse contenant des ions bromures et des ions hydroniums. En particulier, l'acide bromhydrique présente un titre massique de 48%, c'est-à-dire 48 % en masse de HBr par rapport à la masse totale de la solution aqueuse.

Le bromure d'hydrogène est un gaz de formule HBr.

Un sel de bromure est un sel comprenant des ions bromures, comme par exemple le bromure de sodium, le bromure de potassium ou le bromure d'ammonium, de préférence le bromure d'ammonium.

Dans une première variante, la composition B est choisie parmi une composition aqueuse comprenant de l'acide bromhydrique, une composition aqueuse comprenant au moins un sel de bromure ou leur mélange.

De préférence, la composition B est choisie parmi de l'acide bromhydrique, une composition aqueuse comprenant au moins un sel de bromure ou leur mélange.

Dans une seconde variante, la composition B est une composition gazeuse comprenant du bromure d'hydrogène.

De préférence, la composition B est du bromure d'hydrogène.

Dans une troisième variante, la composition B est une composition solide comprenant au moins un sel de bromure.

La concentration molaire en ions bromure dans la composition C selon l'invention, lors du mélange de la composition B avec la composition H, est comprise entre 0,15 mol/L et 0,45 mol/L, de préférence entre 0,2 mol/L et 0,4 mol/L.

Lorsque la source d'ions bromure est l'acide bromhydrique, la concentration volumique en acide bromhydrique dans la composition C est de préférence comprise entre 2% et 5,5%, en particulier lorsque l'acide bromhydrique présente un titre massique de 48%.

Lorsque la source d'ions bromure est l'acide bromhydrique, ledit acide bromhydrique a de préférence un titre massique de 48%. Ce produit au titre massique indiqué est facilement trouvable dans le commerce, ce qui facilite la préparation de la composition B.

De même, lorsque la concentration molaire en ions bromure dans la composition C est supérieure à 0,45 mol/L, l'efficacité n'est pas améliorée par rapport à une concentration molaire inférieure à 0,45 mol/L, et on excède alors la solubilité du dibrome Br₂ formé dans l'eau, ce qui conduit à la nécessité d'éliminer le dibrome Br₂ ainsi généré sous forme de gaz.

De même, lorsque la concentration molaire en ions bromure dans la composition C est inférieure à 0,15 mol/L, l'efficacité de la composition C est réduite.

De préférence, la composition chimique de l'invention comprend en outre de l'acide chlorhydrique, ce qui permet d'améliorer encore l'efficacité du nettoyage.

En particulier, la composition B selon l'invention comprend en outre des ions chlorures à un ratio molaire par rapport aux ions bromures inférieur ou égal à 0,25.

Le ratio molaire ions chlorures/ions bromure dans la composition B est donc inférieur ou égal à 0,25, de préférence compris entre 0 et 0,25.

Ainsi, dans la composition C, au moment du mélange de la composition B et de la composition H, le ratio molaire ions chlorures/ions bromure est inférieur ou égal à 0,25, de préférence compris entre 0 et 0,25.

La source d'ions chlorure peut être l'acide chlorhydrique.

L'acide chlorhydrique est une solution aqueuse de chlorure d'hydrogène. Il est obtenu par dissolution du gaz HCl dans de l'eau. Il s'agit d'une solution aqueuse contenant des ions chlorures et des ions hydroniums. En particulier, l'acide chlorhydrique présente un titre massique de 37%, c'est-à-dire 37% en masse de HCl par rapport à la masse totale de la solution aqueuse.

Un ratio molaire ions chlorures/ions bromure supérieure à 0,25 dans la composition C n'augmente guère plus l'efficacité du nettoyage, et la pression de vapeur de l'acide chlorhydrique dans le mélange augmente significativement.

Avantageusement, la composition B est constituée d'une source d'ions bromures, éventuellement d'eau et éventuellement d'une source d'ions chlorure. Plus avantageusement, la composition B est constituée d'une source d'ions bromures, d'eau et éventuellement d'une source d'ions chlorure.

En particulier, la composition B ne comprend pas d'autres anions que les ions bromures et éventuellement les ions chlorures.

### - Composition H

La composition H comprend du peroxyde d'hydrogène.

Le peroxyde d'hydrogène est un composé chimique de formule H₂O₂. Sa solution aqueuse est appelée eau oxygénée.

La source de peroxyde d'hydrogène est en particulier l'eau oxygénée.

Ainsi, de préférence, la composition H comprend de l'eau oxygénée. Plus préférentiellement la composition H est de l'eau oxygénée, signifiant alors que la composition H consiste en de l'eau oxygénée et ne comprend pas d'autres éléments.

L'eau oxygénée a de préférence un titre massique de 30%, c'est-à-dire 30 % en masse de H₂O₂ par rapport à la masse totale de la solution aqueuse.

Le ratio molaire en peroxyde d'hydrogène/ions bromures dans la composition C, lors du mélange, est compris entre 1,1 et 2. Ainsi, la concentration molaire en peroxyde d'hydrogène dans la composition C, lors du mélange, peut être comprise entre 0,16 mol/L et 0,9 mol/L.

De même, lorsque la concentration molaire en peroxyde d'hydrogène dans la composition C est supérieure à 0,9 mol/L, ou lorsque le ratio molaire en peroxyde d'hydrogène/ions bromures dans la composition C est supérieur à 2, l'efficacité n'est pas améliorée par rapport à une concentration molaire inférieure à 0,9 mol/L.

Lors du mélange, la concentration molaire en peroxyde d'hydrogène dans la composition C est supérieure à la concentration molaire en ions bromure dans la composition C. Dans le cas contraire, l'efficacité de la composition est réduite.

### Procédé de retrait selon l'invention

La présente invention porte également sur un procédé de retrait sélectif de résidus d'un alliage nickel-platine contenant au moins 8% massique de Pt par rapport au poids total de l'alliage nickel-platine d'un substrat, avantageusement d'un transistor, comprenant l'utilisation de la composition chimique aqueuse C selon l'invention. L'alliage nickel-platine du substrat comprend en particulier au moins 8% en masse de platine, avantageusement de 8% à 15% en masse de platine, par rapport au poids total de l'alliage nickel-platine. De préférence, l'utilisation de la composition chimique selon l'invention consiste à mettre en contact le substrat à traiter avec la composition aqueuse C selon l'invention.

Avantageusement, la présente invention concerne un procédé de retrait sélectif de résidus d'un alliage nickel-platine contenant au moins 8% massique de Pt par rapport au poids total de l'alliage nickel-platine d'un substrat, comprenant les étapes suivantes :
a) préparer à chaud une composition chimique aqueuse C selon l'invention,
b) mettre en contact la composition chimique aqueuse C à une température supérieure ou égale à 70°C et le substrat pendant une durée suffisante pour retirer les résidus en alliage nickel-platine du substrat.

### Etape a)

En particulier, la composition aqueuse C est préparée par mélange d'une composition B comprenant des ions bromure et d'une composition H comprenant du peroxyde d'hydrogène de sorte que dans la composition C, au moment du mélange, la concentration molaire en ions bromure est comprise entre 0,15 mol/L et 0,45 mol/L et le ratio molaire du peroxyde d'hydrogène par rapport aux ions bromures est compris entre 1,1 et 2.

Plus particulièrement, les compositions B, H et C sont telles que décrite ci-dessus.

Avantageusement, la composition B est chauffée à une température supérieure à 70°C, plus préférentiellement supérieure à 75°C, en particulier comprise entre 75°C et 95°C, avant de la mélanger avec la composition H.

En particulier, la composition aqueuse C est préparée par mélange d'une composition B, d'une composition H et d'eau. Plus particulièrement, l'eau est chauffée à une température supérieure à 70°C, plus préférentiellement supérieure à 75°C, en particulier comprise entre 75°C et 95°C, avant de la mélanger aux compositions B et H.

De manière alternative, l'eau et la composition B sont mélangées et chauffées à une température supérieure à 70°C, plus préférentiellement supérieure à 75°C, en particulier comprise entre 75°C et 95°C, avant de les mélanger à la composition H.

Dans une première variante, comme illustré dans la figure 5, l'étape de mélange a lieu en injectant la composition B et la composition H dans un flux d'eau E en un même point d'injection pour former un flux de composition aqueuse C selon l'invention. Le point d'injection PIB de la composition B et le point d'injection PIH de la composition H est commun et correspond alors au point de contact PC des deux compositions B et H.

De préférence, les injections des compositions B et H ont lieu de manière simultanée.

Dans cette variante, les concentrations molaires en ions bromures et en peroxyde d'hydrogène sont déterminées lors du contact des ions bromures et du peroxyde d'hydrogène, c'est-à-dire au point de contact PC des compositions B et H. Ainsi, le point de contact PC correspond au mélange des compositions B et H.

Dans une seconde variante, comme illustré dans la figure 6, l'étape de mélange a lieu en injectant la composition B en un point d'injection PIB dans un flux d'eau E et en injectant la composition H dans ledit flux d'eau E en un point d'injection PIH, le point d'injection PIB étant en amont du point d'injection PIH, pour former un flux de composition aqueuse C selon l'invention. Le point d'injection PIH correspond alors au point de contact PC des deux compositions B et H.

De préférence, les injections des compositions B et H ont lieu de manière simultanée.

Dans cette variante, les concentrations molaires en ions bromures et en peroxyde d'hydrogène sont déterminées lors du contact des ions bromures et du peroxyde d'hydrogène, c'est-à-dire au point de contact PC des compositions B et H. Ainsi, le point de contact PC, qui est aussi le point d'injection PIH, correspond au mélange des compositions B et H

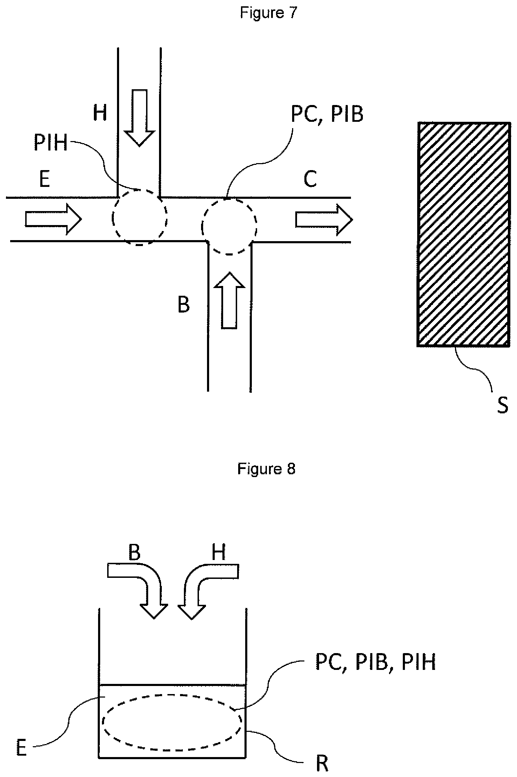

Dans une troisième variante, comme illustré dans la figure 7, l'étape de mélange a lieu en injectant la composition H en un point d'injection PIH dans un flux d'eau E et en injectant la composition B dans ledit flux d'eau E en un point d'injection PIB, le point d'injection PIH étant en amont du point d'injection PIB, pour former un flux de composition aqueuse C selon l'invention. Le point d'injection PIB correspond alors au point de contact PC des deux compositions B et H.

De préférence, les injections des compositions B et H ont lieu de manière simultanée.

Dans cette variante, les concentrations molaires en ions bromures et en peroxyde d'hydrogène sont déterminées lors du contact des ions bromures et du peroxyde d'hydrogène, c'est-à-dire au point de contact PC des compositions B et H. Ainsi, le point de contact PC, qui est aussi le point d'injection PIB, correspond au mélange des compositions B et H

Dans les première, seconde et troisième variantes, de préférence, le flux d'eau est à une température supérieure à 70°C, plus préférentiellement supérieure à 75°C, en particulier comprise entre 75°C et 95°C.

Dans les première, seconde et troisième variantes, en particulier, la composition B comprend de l'acide bromhydrique et la composition H comprend de l'eau oxygénée. Plus particulièrement, l'étape de mélange a lieu en injectant dans un flux d'eau de l'acide bromhydrique et de l'eau oxygénée.

Dans les première, seconde et troisième variantes, avantageusement, le mélange a lieu en injectant dans un flux d'eau de l'acide bromhydrique titré à 48% en masse, à un débit volumique compris entre 2% et 5,5% du débit volumique d'eau, et de l'eau oxygénée titrée à 30% en masse, à un débit volumique compris entre 0,5 fois et deux fois le débit volumique de l'acide bromhydrique.

Dans les première, seconde et troisième variantes, avantageusement, le mélange a lieu en injectant dans un flux d'eau de l'acide bromhydrique titré à 48% en masse, à un débit volumique compris entre 2% et 5,5% du débit volumique d'eau, et de l'eau oxygénée titrée à 30% en masse, à un débit volumique compris entre une fois et deux fois le débit volumique de l'acide bromhydrique.

Dans les première, seconde et troisième variantes, en particulier, le mélange a lieu en injectant dans un flux d'eau de l'acide bromhydrique titré à 48% en masse, à un débit volumique compris entre 2% et 5,5% du débit volumique d'eau, et de l'eau oxygénée titrée à 30% en masse, à un débit volumique compris entre 0,63 fois et 1,14 fois le débit volumique de l'acide bromhydrique.

Dans les première, seconde et troisième variantes, de préférence, la composition B comprend du bromure d'hydrogène et la composition H comprend de l'eau oxygénée, et l'étape de mélange a lieu en injectant de l'eau oxygénée et en diffusant du bromure d'hydrogène dans un flux d'eau.

Selon un mode de réalisation préféré, la composition est fabriquée en injectant au point d'utilisation, dans un flux d'eau chauffée à une température supérieure à 75°C, une petite quantité d'ions bromure, issus de l'acide bromhydrique titré à 48% en masse, a un débit compris entre 2% et 5,5% du débit volumique d'eau, et un débit d'eau oxygénée, titrée à 30% en masse, compris entre 2% et 6 % du débit volumique d'eau.

Fabriquer la composition au point d'utilisation signifie que la source d'ions bromure, l'eau oxygénée, et l'eau sont mélangés juste avant la mise en contact de la composition obtenue avec le substrat à nettoyer. Le débit total du mélange de ces trois constituants, formant la composition, est choisi en fonction de la méthode utilisée pour mettre en contact ladite composition avec le substrat à nettoyer.

Dans une quatrième variante, comme illustré dans la figure 8, la composition B et la composition H sont mélangées dans un réservoir R comprenant ou non de l'eau E.

Avantageusement, la composition B, la composition H et optionnellement l'eau sont mélangés et chauffés dans un réservoir R, plus avantageusement à une température supérieure à 70°C, plus préférentiellement supérieure à 75°C, en particulier comprise entre 75°C et 95°C.

En particulier, la composition B est mélangée avec de l'eau dans le réservoir R, puis la composition H est ajoutée. Plus particulièrement, la composition B est mélangée avec de l'eau dans le réservoir R, puis chauffée avantageusement à une température supérieure à 70°C, plus préférentiellement supérieure à 75°C, en particulier comprise entre 75°C et 95°C, puis la composition H est ajoutée.

Alternativement, la composition H est mélangée avec de l'eau, puis la composition B est ajoutée. De préférence, la composition H est mélangée avec de l'eau, puis la composition B est ajoutée pour obtenir la composition C qui est ensuite chauffée avantageusement à une température supérieure à 70°C, plus préférentiellement supérieure à 75°C, en particulier comprise entre 75°C et 95°C.

Selon un mode de réalisation, les ions bromure, l'eau oxygénée et l'eau sont mélangés et chauffés dans un réservoir, puis le substrat est immergé dans le mélange à l'intérieur du réservoir. La mise en contact du substrat et de la composition s'effectue alors par immersion du substrat dans la composition. D'autres techniques de mise en contact du substrat et de la composition sont utilisables sans pour autant sortir du cadre de l'invention, telle que par exemple l'aspersion du substrat avec la composition.

La solution est mise en oeuvre à une température supérieure ou égale à 70°C, afin de réduire le temps de nettoyage.

Dans ce cas, lors de la fabrication de la composition, l'eau est de préférence chauffée à une température supérieure à 75°C puis mélangée à cette température à l'eau oxygénée et aux ions bromure, de sorte que la composition obtenue ait une température supérieure ou égale à 70°C.

### Etape b)

La composition aqueuse C décrite précédemment est mise au contact du substrat à traiter pendant une durée suffisante pour retirer les résidus en alliage nickel-platine du substrat.

Le temps de mise en contact correspond au temps minimum nécessaire pour obtenir un retrait complet des résidus, et est fonction des conditions d'utilisation, notamment de l'équipement industriel utilisé. Ce procédé présente l'avantage d'être directement utilisable par la plupart des équipements de traitement humide, sans impliquer de modification notable dans la chaine de production.

En particulier, la durée suffisante pour retirer les résidus en alliage nickel-platine du substrat est comprise entre 30 sec et 10 min, de préférence entre 1 min et 8 min, plus préférentiellement entre 2 min et 7 min.

La mise en contact du substrat et de la composition aqueuse C peut s'effectuer par immersion du substrat dans la composition C, en particulier lorsque la composition C est préparée selon la troisième variante décrite du procédé de préparation.

D'autres techniques de mise en contact du substrat et de la composition aqueuse C sont utilisables sans pour autant sortir du cadre de l'invention.

Notamment, la mise en contact du substrat et de la composition aqueuse C peut s'effectuer par l'aspersion du substrat avec la composition C, en particulier lorsque la composition C est préparée selon la première, la seconde ou la troisième variante décrite du procédé de préparation de la composition C. Lors de la préparation de la composition aqueuse C selon la première, seconde et troisième variante, le débit total du mélange de la source d'ions bromure, de la source d'eau oxygénée et de l'eau, formant la composition C, est choisi en fonction de la méthode utilisée pour mettre en contact ladite composition C avec le substrat à nettoyer.

En particulier, la composition aqueuse C est à une température supérieure ou égale à 70°C, plus particulièrement supérieure ou égale à 75°C, encore plus particulièrement comprise entre 75°C et 95°C lors de sa mise en contact avec le substrat.

En particulier les résidus à retirer sélectivement sont des résidus d'un alliage Ni-Pt contenant au moins 8% en masse de platine, avantageusement de 8% à 15% en masse de platine, par rapport au poids total de l'alliage nickel-platine.

Avantageusement, le substrat est une structure de transistor comprenant les résidus en alliage nickel-platine formés par recuit lors de la fabrication du transistor.

De préférence, le transistor est un transistor MOS, plus préférentiellement fabriqué selon les figures 1A, 1B, 1C, 1D et 1E, notamment fabriqué selon la méthode décrite dans le paragraphe de l'état de la technique.

En particulier, l'étape b) suit immédiatement l'étape a). En d'autres termes, la composition C obtenue à l'étape a) est directement utilisée dans l'étape b), notamment sans étape de stockage de la composition C.

### EXEMPLE

### Retrait de résidus en alliage nickel-platine d'un substrat lors de la fabrication d'un transistor

On utilise des coupons comprenant chacun une structure comprenant un dépôt de nickel platine à 10% massique de platine d'environ 10 nm d'épaisseur, surmonté d'une couche de nitrure de titane d'environ 10 nm d'épaisseur ayant subi un premier recuit de température pour former une première phase de siliciure riche en métaux.

Dans les exemples 1 à 5, on immerge les coupons dans 5 béchers de 50 mL dans lesquels un mélange d'acide bromhydrique présentant un titre massique de 48% et d'eau a d'abord été chauffé jusqu'à la température d'utilisation, puis de l'eau oxygénée présentant un titre massique de 30% a été ajoutée juste avant l'immersion des coupons selon les proportions indiquées dans le tableau 1 ci-dessous.

Dans l'exemple 6, on immerge les coupons dans 1 bécher de 50 mL dans lequel un mélange d'acide bromhydrique présentant un titre massique de 48%, d'acide chlorhydrique présentant un titre massique de 37% et d'eau a d'abord été chauffé jusqu'à la température d'utilisation, puis de l'eau oxygénée a été ajoutée juste avant l'immersion des coupons selon les proportions indiquées dans le tableau 1 ci-dessous.

Dans l'exemple 7, on immerge les coupons dans 1 bécher de 50 mL dans lequel un mélange d'acide chlorhydrique présentant un titre massique de 37% et d'eau a d'abord été chauffé jusqu'à la température d'utilisation, puis de l'eau oxygénée présentant un titre massique de 30% a été ajoutée juste avant l'immersion des coupons selon les proportions indiquées dans le tableau 2 ci-dessous.

Dans les 7 exemples, pendant tout le temps de l'immersion, les coupons ont été lentement agités.

Les exemples 4 et 7 sont des exemples hors invention permettant d'illustrer la portée de la présente invention.

On sort les coupons des béchers, puis on les observe au microscope électronique à balayage afin de déterminer la présence ou non de résidus d'alliage nickel-platine.

Des coupons pleine plaque (sans structure) de siliciures recouverts des mêmes dépôts de nickel platine et de nitrure de titane, et ayant subi le même recuit ont été utilisés pour déterminer l'agressivité de la solution vis-à-vis des siliciures et plongés en même temps que les coupons structurés à chaque test.

Une mesure de résistance par sonde quatre pointes permet de vérifier l'innocuité de la solution pour le siliciure formé, une valeur de 6,9 à 7,1 Ω correspond à l'épaisseur du siliciure formé.

Les résultats sont donnés dans le tableau ci-dessous.

**[Table 1]**

| Exemple | HBr (48%) vol% | Br-(mol/L) | Ratio molaire HCl/Br- | H2O2 (30%) vol% | Ratio molaire H2O2/Br- | Eau Température (°C) | Temps (min) | Résidus (O/N) | Siliciure (R² - Ω) |
|---|---|---|---|---|---|---|---|---|---|
| 1 | 3 | 0,25 | 0 | 4.5 | 1,6 | 80 | 3.5 | N | 7 |
| 2 | 2 | 0,17 | 0 | 2 | 1,1 | 80 | 5.5 | N | 6.9 |
| 3 | 5 | 0,40 | 0 | 6 | 1,3 | 80 | 2.5 | N | 7.1 |
| 4 | 3 | 0,25 | 0 | 2 | 0,7 | 80 | 3.5 | O | 6.8 |
| 5 | 3 | 0,25 | 0 | 4.5 | 1,6 | 65 | 6 | O | 6.6 |
| 6 | 3 | 0,25 | 0,17 | 4.5 | 1,6 | 80 | 2.5 | N | 6.9 |

**[Table 2]**

| Exemple | HCl (37%) vol% | Cl-(mol/L) | H2O2 (30%) vol% | Ratio molaire H2O2/Cl- | Eau Température (°C) | Temps (min) | Résidus (O/N) | Siliciure (R² - Ω) |
|---|---|---|---|---|---|---|---|---|
| 7 | 5 | 0,61 | 5 | 0,8 | 80 | 5 | O | 7,8 |

Dans les exemples 1, 2, et 3, les constituants des compositions utilisées ont une concentration molaire incluse dans les gammes décrites précédemment entre 0,15 mol/L et 0,45 mol/L pour les ions bromure, et un ratio molaire entre 1,1 et 2 pour l'eau oxygénée.

En particulier, la composition de l'exemple 1 comprend des concentrations molaires moyennes en ions bromure et en eau oxygénée, la composition de l'exemple 2 comprend des concentrations molaires correspondant aux bornes inférieures, et la composition de l'exemple 3 comprend une concentration molaire en ions bromures correspondant à la borne supérieure des ions bromures.

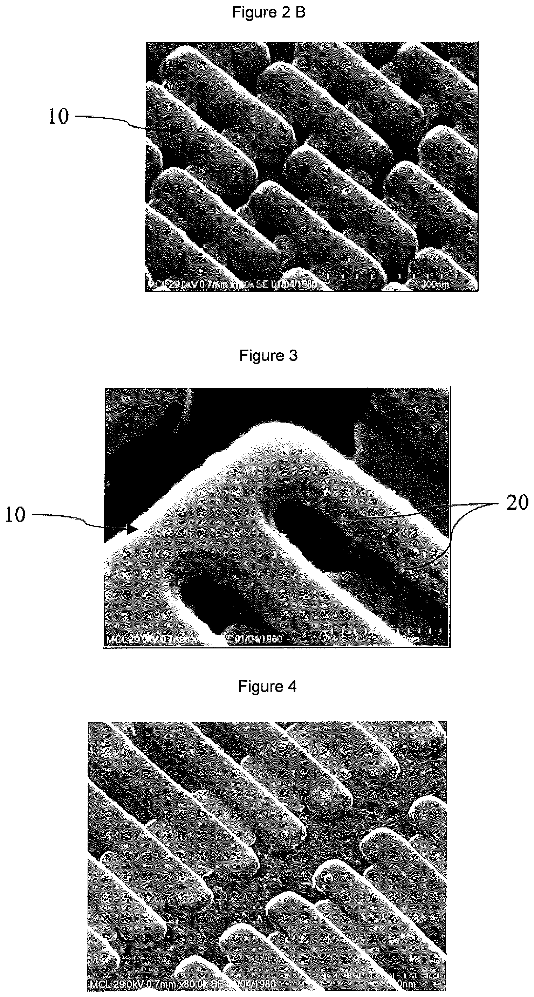

Pour ces trois exemples 1, 2, et 3, les résidus sont totalement éliminés (résidus absents, symbole N), et ce quel que soit le temps de mise en contact de la composition avec le substrat (temps de nettoyage). Ceci est confirmé par les figures 2A et 2B qui représentent des vues au microscope électronique à balayage de la structure du transistor 10 après nettoyage, sur lesquelles aucun résidu n'est visible.

L'exemple 4 diffère de l'exemple 1 en ce que le ratio molaire en eau oxygénée par rapport aux ions bromures est égale à 0,7. Dans ce cas, les résidus ne sont pas totalement éliminés (résidus présents, symbole O), malgré un temps de nettoyage moyen. Ceci est confirmé par la figure 3 qui représente une vue au microscope électronique à balayage de la structure du transistor 10 après nettoyage, sur laquelle des résidus 20 sont encore visibles sous la forme de petites taches de surface.

L'exemple 5 diffère de l'exemple 1 en ce que la température de l'eau, approximativement égale de la température de la composition, est de 65°C, c'est-à-dire en dessous de 70°C. Dans ce cas, les résidus ne sont pas totalement éliminés, malgré un temps de nettoyage plus important.

L'exemple 6 diffère de l'exemple 1 par la présence supplémentaire d'acide chlorhydrique dans la composition, et permet d'avoir un nettoyage très efficace en un temps réduit.

Dans l'exemple 7, la présence unique d'acide chlorhydrique ne permet pas d'avoir un nettoyage complet des structures. Ceci est confirmé par la figure 4 qui représente une vue au microscope électronique à balayage de la structure du transistor 10 après nettoyage sur laquelle des résidus sont encore visibles sous la forme de taches de surface « grille de platine ». De plus, il semble que le siliciure commence à être attaqué.

## Revendications

1. Composition chimique aqueuse C pour retirer d'un substrat sélectivement à chaud des résidus d'un alliage nickel-platine contenant au moins 8% massique de Pt par rapport au poids total de l'alliage nickel-platine, **caractérisée en ce qu'**elle est préparée par mélange d'une composition B comprenant des ions bromure et d'une composition H comprenant du peroxyde d'hydrogène de sorte que dans la composition C, au moment du mélange, la concentration molaire en ions bromure est comprise entre 0,15 mol/L et 0,45 mol/L et le ratio molaire du peroxyde d'hydrogène par rapport aux ions bromures est compris entre 1,1 et 2.

2. Composition chimique selon la revendication 1, dans laquelle la composition B comprend de l'acide bromhydrique, un sel de bromure ou du bromure d'hydrogène.

3. Composition chimique selon la revendication 1, **caractérisée en ce que** la composition B comprend en outre des ions chlorures à un ratio molaire par rapport aux ions bromures inférieur ou égal à 0,25.

4. Utilisation de la composition chimique selon l'une quelconque des revendications 1 à 3 pour retirer d'un substrat sélectivement à une température supérieure ou égale à 70°C, des résidus d'un alliage nickel-platine contenant au moins 8% massique de Pt par rapport au poids total de l'alliage nickel-platine.

5. Procédé de retrait sélectif de résidus en alliage nickel-platine contenant au moins 8% massique de Pt par rapport au poids total de l'alliage nickel-platine d'un substrat, comprenant les étapes suivantes :
- préparer à chaud une composition chimique C selon l'une quelconque des revendications 1 à 3,
- mettre en contact la composition chimique C chaude et le substrat pendant une durée suffisante pour retirer les résidus en alliage nickel-platine du substrat,
**caractérisé en ce que** la composition chimique C est à une température supérieure ou égale à 70°C lors de sa mise en contact avec le substrat.

6. Procédé selon la revendication 5, dans lequel la composition chimique est préparée en chauffant la composition B comprenant les ions bromures à une température supérieure à 75°C avant ajout de la composition H comprenant le peroxyde d'hydrogène.

7. Procédé selon la revendication 5 ou 6, dans lequel la composition chimique C est préparée en injectant dans un flux d'eau de l'acide bromhydrique présentant un titre massique de 48%, en tant que composition B, à un débit compris entre 2% et 5,5% du débit volumique d'eau, et de l'eau oxygénée présentant un titre massique de 30%, en tant que composition H, à un débit volumique compris entre une et deux fois le débit volumique de l'acide bromhydrique.

8. Procédé selon l'une quelconque des revendications 5 à 7, dans lequel le substrat est une structure de transistor comprenant les résidus en alliage nickel-platine formés par recuit lors de la fabrication du transistor.

9. Procédé selon l'une quelconque des revendications 5 à 8, dans lequel les résidus à retirer sélectivement sont des résidus d'un alliage Ni-Pt contenant de 8% à 15% en masse de platine, par rapport au poids total de l'alliage nickel-platine.

## Patentansprüche

1. Wässrige chemische Zusammensetzung C zum selektiven warmen Entfernen der Rückstände einer Nickel-Platin-Legierung, die mindestens 8 Massenprozent Pt bezogen auf das Gesamtgewicht der Nickel-Platin-Legierung enthält, von einem Substrat, **dadurch gekennzeichnet, dass** sie durch Mischen einer Zusammensetzung B, die Bromidionen umfasst, und einer Zusammensetzung H, die Wasserstoffperoxid umfasst, hergestellt wird, so dass in der Zusammensetzung C zum Zeitpunkt des Mischens die molare Konzentration an Bromidionen zwischen 0,15 mol/L und 0,45 mol/L liegt und das Molverhältnis des Wasserstoffperoxids zu den Bromidionen zwischen 1,1 und 2 liegt.

2. Chemische Zusammensetzung nach Anspruch 1, wobei die Zusammensetzung B Bromwasserstoffsäure, ein Bromidsalz oder Bromwasserstoff umfasst.

3. Chemische Zusammensetzung nach Anspruch 1, **dadurch gekennzeichnet, dass** die Zusammensetzung B ferner Chloridionen in einem Molverhältnis zu den Bromidionen von weniger als oder gleich 0,25 umfasst.

4. Verwendung der chemischen Zusammensetzung nach einem der Ansprüche 1 bis 3 zum selektiven Entfernen der Rückstände einer Nickel-Platin-Legierung, die mindestens 8 Massenprozent Pt bezogen auf das Gesamtgewicht der Nickel-Platin-Legierung enthält, von einem Substrat bei einer Temperatur von über oder gleich 70°C.

5. Verfahren zum selektiven Entfernen von Nickel-Platin-Legierungs-Rückständen, die mindestens 8 Massenprozent Pt bezogen auf das Gesamtgewicht der Nickel-Platin-Legierung enthalten, von einem Substrat, umfassend die folgenden Schritte:
- Warmaufbereitung einer chemischen Zusammensetzung C nach einem der Ansprüche 1 bis 3,
- Inkontaktbringen der warmen chemischen Zusammensetzung C mit dem Substrat für eine Zeit, die zum Entfernen der Nickel-Platin-Legierungs-Rückstände vom Substrat ausreichend ist,
**dadurch gekennzeichnet, dass** die chemische Zusammensetzung C bei ihrem Inkontaktbringen mit dem Substrat eine Temperatur von über oder gleich 70°C hat.

6. Verfahren nach Anspruch 5, wobei die chemische Zusammensetzung durch Erwärmen der Bromidionen enthaltenden Zusammensetzung B auf eine Temperatur von über 75°C vor Zugabe der Wasserstoffperoxid enthaltenden Zusammensetzung H hergestellt wird.

7. Verfahren nach Anspruch 5 oder 6, wobei die chemische Zusammensetzung C hergestellt wird, indem in einen Wasserstrom Bromwasserstoffsäure mit einem Massegehalt von 48% als Zusammensetzung B mit einer Durchflussrate zwischen 2% und 5,5% der Wasservolumenstromrate und Wasserstoffperoxid mit einem Massengehalt von 30% als Zusammensetzung H mit einer Volumenstromrate zwischen dem Ein- und Zweifachen der Volumenstromrate der Bromwasserstoffsäure eingeleitet wird.

8. Verfahren nach einem der Ansprüche 5 bis 7, wobei das Substrat eine Transistorstruktur ist, die die Nickel-Platin-Legierungs-Rückstände umfasst, die durch Glühen bei der Herstellung des Transistors gebildet wurden.

9. Verfahren nach einem der Ansprüche 5 bis 8, wobei die selektiv zu entfernenden Rückstände Rückstände einer Ni-Pt-Legierung sind, die 8 bis 15 Ma-% Platin, bezogen auf das Gesamtgewicht der Nickel-Platin-Legierung, enthält.

## Claims

1. Aqueous chemical composition C for removing from a substrate selectively under heat residues of a nickel-platinum alloy containing at least 8% by weight of Pt compared to the total weight of nickel-platinum alloy, **characterised in that** it is prepared by mixing a composition B comprising bromide ions and a composition H comprising hydrogen peroxide such that in the composition C, at the moment of mixing, the molar concentration of bromide ions is comprised between 0.15 mol/L and 0.45 mol/L and the molar ratio of hydrogen peroxide with respect to bromide ions is comprised between 1.1 and 2.

2. Chemical composition according to claim 1, in which the composition B comprises hydrobromic acid, a bromide salt or hydrogen bromide.

3. Chemical composition according to claim 1, **characterised in that** the composition B further comprises chloride ions at a molar ratio with respect to bromide ions less than or equal to 0.25.

4. Use of the chemical composition according to any one of claims 1 to 3 for removing from a substrate selectively at a temperature greater than or equal to 70°C residues of a nickel-platinum alloy containing at least 8% by weight of Pt compared to the total weight of nickel-platinum alloy.

5. Method for selectively removing nickel-platinum alloy residues containing at least 8% by weight of Pt compared to the total weight of nickel-platinum alloy from a substrate, comprising the following steps:
- preparing under heat a chemical composition C according to any one of claims 1 to 3,
- placing the hot chemical composition C and the substrate in contact for a sufficient duration to remove the nickel-platinum alloy residues from the substrate,
**characterised in that** the chemical composition C is at a temperature greater than or equal to 70°C while it is placed in contact with the substrate.

6. Method according to claim 5, wherein the chemical composition is prepared by heating the composition B comprising the bromide ions to a temperature greater than 75°C before addition of the composition H comprising hydrogen peroxide.

7. Method according to claim 5 or 6, wherein the chemical composition C is prepared by injecting into a flow of water hydrobromic acid having a mass concentration of 48%, as composition B, at a flow rate comprised between 2% and 5.5% of the water volumetric flow rate, and hydrogen peroxide aqueous solution having a mass concentration of 30%, as composition H, at a volumetric flow rate comprised between one and two times the hydrobromic acid volumetric flow rate.

8. Method according to any one of claims 5 to 7, wherein the substrate is a transistor structure comprising nickel-platinum alloy residues formed by annealing during the manufacture of the transistor.

9. Method according to any one of claims 5 to 8, wherein the residues to remove selectively are residues of a Ni-Pt alloy containing from 8% to 15% by weight of platinum, compared to the total weight of nickel-platinum alloy.
